# EUROPÄISCHE PATENTANMELDUNG

(11) **EP 4 651 176 A1**
(43) Veröffentlichungstag der Anmeldung: **19.11.2025**
(21) Anmeldenummer: 25174521.2
(22) Anmeldetag: 06.05.2025
(51) Int. Cl.: H01J 37/32, C23C 14/02, C23C 14/58

(54) **VAKUUMANORDNUNG, VERFAHREN UND VERWENDUNG**

(30) Priorität: 14.05.2024 DE 102024113393
(71) Anmelder: VON ARDENNE Asset GmbH & Co. KG, 01328 Dresden (DE)
(72) Erfinder: Aulhorn, Stephan, 01445 Dresden (DE); Mosshammer, Steffen, 01734 Rabenau, (DE)

(57) **Zusammenfassung**

Gemäß verschiedenen Ausführungsformen weist eine Vakuumanordnung auf: ein Vakuumkammergehäuse (812); eine Transportvorrichtung zum Transportieren eines Substrats entlang eines Transportpfads (111) innerhalb des Vakuumkammergehäuses (812); ein Plasmaquelle (150), welche ein Plasmaquellengehäuse (102) aufweist, in welchem ein Hohlraum (102h) bereitbestellt ist, wobei die Plasmaquelle (150) eingerichtet ist, mittels des Hohlraums (102h) ein Plasma zu bilden, dem der Transportpfad (111) ausgesetzt ist; eine Elektrode (202), welche in dem Vakuumkammergehäuses (812) und neben der Plasmaquelle (150) angeordnet ist; eine Hochfrequenz-Übertragungsvorrichtung (110), welche das Plasmaquellengehäuse (102) ohmsch mit der Elektrode (202) koppelt.

## Beschreibung

Verschiedene Ausführungsbeispiele betreffen eine Vakuumanordnung, ein Verfahren und eine Verwendung.

Im Allgemeinen kann ein Substrat in einem Vakuum behandelt (prozessiert), z.B. beschichtet werden, so dass die chemischen und/oder physikalischen Eigenschaften des Substrats verändert werden können. Zum Beschichten eines Substrats können verschiedene Beschichtungsverfahren durchgeführt werden, wovon die physikalische Gasphasenabscheidung (PVD) ein etablierter Vertreter ist. Beispielsweise kann eine Vakuumbeschichtungsanlage genutzt werden, um eine Schicht oder mehrere Schichten mittels einer chemischen und/oder physikalischen Gasphasenabscheidung auf einem Substrat oder auf mehreren Substraten abzuscheiden.

Für verschiedene Prozesse kann es günstig sein, das Substrat vorzubehandeln oder nachzubehandeln mittels eines Plasmas. Zum Erzeugen des Plasmas kommt eine Plasmaquelle zum Einsatz, welche beispielsweise eine Hohlelektrode aufweist. Diesbezüglich bestehen generell hohe Anforderungen an die Lebensdauer der Plasmaquelle, um Wartungskosten zu reduzieren.

Verschiedene Ausführungsformen basieren auf der Erkenntnis, dass die Lebensdauer der Plasmaquelle selbst von der Lebensdauer einzelner Bauteile begrenzt wird, die selbst dem Plasma ausgesetzt sind. Fällt das Bauteil mit der geringsten Lebensdauer aus, fällt häufig auch die Plasmaquelle als Ganze aus, was eine Wartung nach sich zieht. In dem Zusammenhang wurde erkannt, dass dies bei einer sogenannten Gitterelektrode der Fall ist, womit eine Plasmaquelle häufig ausgestattet ist, wenn diese als Fertiglösung vertrieben wird.

Eine Gitterelektrode kommt zum Einsatz, um die Ausbreitung des Plasmas zu begrenzen, aber dennoch einen Austausch von Atomen, Elektronen und Ionen durch die Gitterelektrode hindurch zu ermöglichen. Dabei ist die Gitterelektrode allerdings selbst dem Plasma ausgesetzt und wird von dem Plasma abgetragen, bis die Gitterelektrode ausfällt. Fällt die Gitterelektrode aus, breitet sich das Plasma in die Vakuumkammer hinein aus und kann andere Bauteile schädigen, beispielsweise Dichtungen, Lager, usw. Daher muss häufig ein Kompromiss eingegangen werden, der entweder zu einem geringen Wartungsintervall führt, um die Gitterelektrode zu ersetzen, oder die Schädigung anderer, teilweise kostenintensiver Bauteile, in Kauf nimmt.

Ebenso steht das Abtragen der Gitterelektrode hohen Anforderungen an die Reinheit des Plasmas entgegen, da die vom Plasma freigesetzten Bestandteile der Gitterelektrode zum Substrat gelangen können, und dieses beispielsweise verunreinigen können. Aufgrund der metallischen Natur der Gitterelektrode kann dies beispielsweise bei Halbleiteranwendungen große Auswirkungen auf die Eigenschaften des Halbleiterprodukts haben.

Gemäß verschiedenen Ausführungsformen werden eine Vakuumanordnung, Verfahren und Verwendung bereitgestellt, welche die räumliche Ausbreitung des Plasmas hemmen, selbst dann, wenn die Gitterelektrode ausgefallen ist oder gar nicht erst zum Einsatz kommt. Beispielsweise kann die Gitterelektrode weggelassen (z.B. vorab demontiert) werden, was die Qualität des Vakuums verbessert.

Anschaulich wurde erkannt, dass die Funktion der Gitterelektrode, die darin besteht, die räumliche Verteilung des elektrischen Feldes, das von der Plasmaquelle zum Erzeugen des Plasmas generiert wird, in dem Vakuumkammergehäuse zu begrenzen, begünstig wird, wenn diese HF-fähig ist. In dem Zusammenhang wurde erkannt, dass das Vakuumkammergehäuse selbst zwar häufig geerdet ist, allerdings dessen Ladungsaustausch mit der Plasmaquelle aufgrund der Eigenschaften des elektrischen Feldes, beispielsweise dessen Hochfrequenz, gehemmt wird.

Anschaulich kann die Stromdichte innerhalb eines elektrischen Leiters mit steigender Frequenz abnehmen (auch als sogenannter Skin-Effekt bezeichnet), so dass die dem Stromfluss entgegenstehende Impedanz des elektrischen Leiters in erster Näherung eine Funktion der Topografie des elektrischen Leiters ist. In diesem Fall erfolgt der Stromfluss näherungsweise primär an der Oberfläche des elektrischen Leiters, wofür ein Vakuumkammergehäuse in der Regel nicht ausgelegt ist. Daher ist die Impedanz des Vakuumkammergehäuses für HF (Hochfrequenz) in der Regel zu hoch, um die Ausbreitung des Plasmas mittels des Vakuumkammergehäuses allein zu hemmen, auch wenn das Vakuumkammergehäuse geerdet ist.

Vor diesem Hintergrund wird eine HF-Übertragungsvorrichtung bereitgestellt, mittels welcher eine Elektrode in dem Vakuumkammergehäuse bereitgestellt wird. Die HF-Übertragungsvorrichtung ist mit der Plasmaquelle gekoppelt und begünstigt einen Ladungsaustausch zwischen der Elektrode und der Plasmaquelle.

Im Folgenden werden verschiedene Beispiele beschrieben, die sich auf vorangehend Beschriebene und in den Figuren Dargestellte beziehen.

Beispiel 1 ist eingerichtet gemäß einem der beigefügten Ansprüche.

Beispiel 2 ist eingerichtet gemäß Anspruch 1 und/oder eine Vakuumanordnung, aufweisend: ein Vakuumkammergehäuses; eine Transportvorrichtung zum Transportieren eines Substrats entlang eines Transportpfads innerhalb des Vakuumkammergehäuses; ein Plasmaquelle, welche ein Plasmaquellengehäuse aufweist, in welchem ein Hohlraum bereitbestellt ist, wobei die Plasmaquelle eingerichtet ist, mittels des Hohlraums ein Plasma zu bilden, dem der Transportpfad ausgesetzt ist; eine Elektrode (auch als Kammerelektrode bezeichnet), welche in dem Vakuumkammergehäuses und (unmittelbar) neben (z.B. entlang des Transportpfads hinter) der Plasmaquelle angeordnet ist; eine HF-Übertragungsvorrichtung, welche das Plasmaquellengehäuse ohmsch mit der Elektrode koppelt.

Beispiel 3 ist eingerichtet gemäß Beispiel 1 oder 2, wobei die Übertragungsvorrichtung ohmsch mit dem Vakuumkammergehäuse gekoppelt oder galvanisch separiert von dem Vakuumkammergehäuse ist (z.B. mittels einer Lagervorrichtung).

Beispiel 4 ist eingerichtet gemäß Beispiel 1 oder 3, ferner eine Lagervorrichtung aufweisend, mittels welcher die Elektrode ohmsch mit dem Vakuumkammergehäuse gekoppelt oder galvanisch separiert von dem Vakuumkammergehäuse gelagert ist; oder wobei die Elektrode an dem Vakuumkammergehäuse (z.B. einer Wand dessen) flächig anliegend befestigt ist.

Beispiel 5 ist eingerichtet gemäß einem der Beispiele 1 bis 4, wobei das Plasmaquellengehäuse zumindest teilweise außerhalb des Vakuumkammergehäuses angeordnet ist und/oder an außerhalb (z.B. an einer Außenseite) des Vakuumkammergehäuses montiert ist.

Beispiel 6 ist eingerichtet gemäß einem der Beispiele 1 bis 5, wobei die Übertragungsvorrichtung eine oder mehr als eine elektrische Leitung aufweist, vorzugsweise wovon: eine erste Leitung in dem Vakuumkammergehäuse angeordnet und/oder mittels einer HF-Litze bereitgestellt ist, und/oder wovon eine zweite elektrische Leitung außerhalb des Vakuumkammergehäuse angeordnet und/oder mittels einer HF-Litze bereitgestellt ist.

Beispiel 7 ist eingerichtet gemäß einem der Beispiele 1 bis 6, wobei die Übertragungsvorrichtung eine oder mehr als eine elektrische HF-Litze aufweist, wovon vorzugsweise: eine erste HF-Litze in dem Vakuumkammergehäuse angeordnet ist (z.B. die erste Leitung bereitstellend) und/oder eine zweite HF-Litze außerhalb des Vakuumkammergehäuse angeordnet ist (z.B. die zweite Leitung bereitstellend).

Beispiel 8 ist eingerichtet gemäß einem der Beispiele 1 bis 7, wobei das Vakuumkammergehäuses (z.B. eine Gehäusewand davon) eine oder mehr als eine Gehäuseöffnung aufweist, wovon in einer ersten Gehäuseöffnung eine Vakuumdurchführung der Übertragungsvorrichtung angeordnet ist und/oder wovon eine zweite Gehäuseöffnung an die Plasmaquelle angrenzt (z.B. den Hohlraum freilegend).

Beispiel 9 ist eingerichtet gemäß einem der Beispiele 1 bis 8, wobei die Vakuumdurchführung einen Kupferstab aufweist, welcher durch die erste Gehäuseöffnung hindurch erstreckt ist und/oder welcher zwei elektrische Leitungen (z.B. HF-Litzen) der Übertragungsvorrichtung ohmsch miteinander koppelt.

Beispiel 10 ist eingerichtet gemäß einem der Beispiele 1 bis 9, wobei die Übertragungsvorrichtung das Plasmaquellengehäuse mit der Elektrode koppelt mittels einer Impedanz, welche einen Wert aufweist in einem Bereich 0,1 Ohm (z.B. 1 Ohm) bis 1 Megaohm (z.B. 1 Kiloohm, z.B. 0,1 Kiloohm, z.B. 10 Ohm), beispielsweise für eine Frequenz in einem Bereich 1 Kilohertz (z.B. 1 Megahertz) bis 100 Megahertz (z.B. 20 Megahertz) einen Wert aufweist und/oder die Betriebsfrequenz der Plasmaquelle.

Beispiel 11 ist eingerichtet gemäß einem der Beispiele 1 bis 10, wobei der Transportpfad in einem Gehäuseinnenraum des Vakuumkammergehäuses angeordnet ist, wobei der Hohlraum mit dem Gehäuseinnenraum fluidleitend gekoppelt ist, z.B. unmittelbar an den Gehäuseinnenraum angrenzt.

Beispiel 12 ist eingerichtet gemäß einem der Beispiele 1 bis 11, welche frei ist von einer (z.B. gitterförmigen und/oder Filament aufweisenden) Elektrode, die zwischen dem Transportpfad und Hohlraum angeordnet ist.

Beispiel 13 ist eingerichtet gemäß einem der Beispiele 1 bis 12, ferner aufweisend: einen Gasseparationskanal, welcher zwei Gasseparationswände aufweist, zwischen denen der Transportpfad angeordnet ist und wovon eine Gasseparationswand die Elektrode bereitstellt, wobei der Gasseparationskanal eingerichtet ist, zwei Prozessierbereiche voneinander gaszuseparieren, wovon ein erster Prozessierbereich der Plasmaquelle ausgesetzt ist und/oder wovon ein zweiter Prozessierbereich einer Beschichtungsvorrichtung (z.B. Sputtervorrichtung) ausgesetzt ist.

Beispiel 14 ist eingerichtet gemäß einem der Beispiele 1 bis 13, wobei die Elektrode plattenförmig ist und/oder eine Montagevorrichtung aufweist, an welcher die HF-Übertragungsvorrichtung befestigt ist.

Beispiel 15 ist eingerichtet gemäß einem der Beispiele 1 bis 14, wobei eine elektrische Impedanz zwischen der Elektrode und dem Plasmaquellengehäuse, welche mittels der Übertragungsvorrichtung bereitgestellt ist, kleiner ist für HF (z.B. zumindest eine Frequenz in einem Bereich 1 MHz bis 100 MHz) als eine elektrisch Impedanz zwischen der Elektrode und dem Plasmaquellengehäuse, welche mittels des Vakuumkammergehäuses bereitgestellt ist.

Beispiel 16 ist eingerichtet gemäß einem der Beispiele 1 bis 15, wobei die Übertragungsvorrichtung separat von dem Vakuumkammergehäuse bereitgestellt ist und/oder von diesem demontiert werden kann.

Beispiel 17 ist eingerichtet gemäß einem der Beispiele 1 bis 16 und/oder ist ein Verfahren zum Betreiben der Vakuumanordnung gemäß einem der Beispiele 1 bis 16, das Verfahren aufweisend: Bilden eines Plasmas mittels der Plasmaquelle, welches zumindest teilweise in dem Hohlraum angeordnet ist; und Transportieren eines Substrats mittels der Transportvorrichtung entlang des Transportpfads an der Plasmaquelle vorbei (z.B. durch einen Prozessierbereich hindurch), so dass das Substrat dem Plasma ausgesetzt ist; wobei ein Vakuum gebildet ist, z.B. in dem Hohlraum und/oder, dem das Substrat ausgesetzt ist.

Beispiel 18 ist eingerichtet gemäß einem der Beispiele 1 bis 17 und/oder ist ein Verfahren zum Betreiben der Vakuumanordnung gemäß einem der Beispiele 1 bis 16, das Verfahren aufweisend: Entfernen einer zusätzlichen (z.B. gitterförmigen) Elektrode, welche den Hohlraum begrenzt und/oder zwischen dem Hohlraum und dem Transportpfad angeordnet ist; Bilden eines Plasmas (z.B. in dem Hohlraum) mittels der Plasmaquelle, welches vorzugsweise zumindest teilweise in dem Hohlraum angeordnet ist und welchem der Transportpfad ausgesetzt ist, wenn die zusätzliche Elektrode entfernt ist (z.B. so dass das Plasma keiner Gitterelektrode ausgesetzt ist); wobei ein Vakuum gebildet ist, z.B. in dem Hohlraum und/oder, dem der Transportpfad ausgesetzt ist.

Beispiel 19 ist eingerichtet gemäß einem der Beispiele 1 bis 18 und/oder ist ein Verwenden einer Wand (z.B. Platte), vorzugsweise Gasseparationswand, welche in einem Vakuumkammergehäuse angeordnet ist, als Elektrode für eine Plasmaquelle, welche ein Plasmaquellengehäuse aufweist, in welchem ein Hohlraum bereitbestellt ist, wobei die Plasmaquelle eingerichtet ist, mittels des Hohlraums ein Plasma zu bilden, wobei die Elektrode mittels einer HF-Übertragungsvorrichtung ohmsch mit dem Plasmaquellengehäuse gekoppelt ist. Dies spart Bauraum.

Beispiel 20 ist eingerichtet gemäß einem der Beispiele 1 bis 19 wobei die Plasmaquelle, eine (z.B. wannenförmige oder topfförmigen) Schutzstruktur (auch als Topf bezeichnet), welche vorzugsweise aus einem Dielektrikum (z.B. aus Glas) besteht und/oder elektrisch isolierend ist, aufweist, welche in dem Hohlraum angeordnet ist, wobei die Schutzstruktur beispielsweise eine Vertiefung bereitstellt, welche in dem Hohlraum angeordnet ist.

Beispiel 21 ist eingerichtet gemäß einem der Beispiele 1 bis 20, wobei die Plasmaquelle eine erste Montagevorrichtung (z.B. einen Flansch) aufweist (z.B. zum Montieren einer Gitterelektrode), welche eine dem Transportpfad zugewandte (z.B. rahmenförmige und/oder abgesetzte) Montagefläche aufweist und in welcher eine Öffnung (welche beispielsweise von der Montagefläche entlang eines in sich geschlossenen Pfads umläuft) gebildet ist, die in dem Hohlraum mündet.

Beispiel 22 ist eingerichtet gemäß einem der Beispiele 1 bis 21, wobei das Plasmaquellengehäuse eine zweite Montagevorrichtung (z.B. einen nach außen auskragenden Flansch) aufweist, welcher den Hohlraum und/oder die erste Montagevorrichtung entlang eines in sich geschlossenen Pfads umläuft, wobei die zweite Montagevorrichtung eingerichtet ist, vakuumdicht mit dem Vakuumkammergehäuse zusammengefügt zu werden.

Beispiel 23 ist eingerichtet gemäß einem der Beispiele 1 bis 22, wobei die Plasmaquelle eine Elektrode (auch als Hauptelektrode bezeichnet) aufweist, welche in dem Hohlraum angeordnet ist und/oder diesen begrenzt, wobei die Plasmaquelle vorzugsweise einen elektrischen Anschluss aufweist, der mit der Elektrode elektrisch gekoppelt ist. Beispielsweise kann die Elektrode galvanisch von dem Plasmaquellengehäuse separiert gelagert sein.

Beispiel 24 ist eingerichtet gemäß einem der Beispiele 1 bis 23, wobei eine Betriebsfrequenz der Plasmaquelle zum Bilden eines Plasmas in dem Hohlraum eine Hochfrequenz ist und/oder in einem Bereich ist von ungefähr 1 Kilohertz (z.B. 1 MHz (Megahertz)) bis ungefähr 1 THz (Terahertz), z.B. bis ungefähr 1 GHz (Gigahertz).

Beispiel 25 ist eingerichtet gemäß einem der Beispiele 1 bis 24, wobei die HF-Übertragungsvorrichtung parallel zu dem Vakuumkammergehäuse geschaltet ist.

Beispiel 26 ist eingerichtet gemäß einem der Beispiele 1 bis 25, wobei die Übertragungsvorrichtung einen oder mehr als einen elektrischen Leiter (z.B. die elektrische HF-Litze) aufweist, welcher ein Geflecht aufweist, das beispielsweise eine Vielzahl von Filamenten aufweist.

Beispiel 27 ist eingerichtet gemäß einem der Beispiele 1 bis 26, wobei die HF-Übertragungsvorrichtung mehr Filamente aufweist als das Vakuumkammergehäuse und/oder als die Plasmaquelle (z.B. eine Gitterelektrode davon).

Beispiel 28 ist eingerichtet gemäß einem der Beispiele 1 bis 27, wobei die HF-Übertragungsvorrichtung einen größeren Anteil Kupfer und/oder Silber aufweist als das Vakuumkammergehäuse.

Beispiel 29 ist eingerichtet gemäß einem der Beispiele 1 bis 28, wobei die Plasmaquelle eingerichtet ist, an dieser eine Gitterelektrode (auch als Schutzgitter bezeichnet) zu montieren, welche den Hohlraum begrenzt, wobei die Gitterelektrode vorzugsweise demontiert ist.

Beispiel 30 ist eingerichtet gemäß einem der Beispiele 1 bis 29, wobei die Plasmaquelle einen dielektrischen Topf aufweist, welcher in dem Hohlraum angeordnet ist.

Beispiel 31 ist eingerichtet gemäß einem der Beispiele 1 bis 30, wobei die Plasmaquelle eingerichtet ist, zumindest einen Teil des Plasmas (z.B. als Plasmastrahl) zu emittieren, z.B. (vorzugsweise in eine Emissionsrichtung) zu dem Transportpfad hin und/oder aus dem Hohlraum heraus gerichtet ist.

Beispiel 32 ist eingerichtet gemäß einem der Beispiele 1 bis 31, wobei die Plasmaquelle im Betrieb zumindest einen unneutralisierten Teil des Plasmas emittiert, z.B. zu dem Transportpfad hin und/oder aus dem Hohlraum heraus gerichtet ist.

Beispiel 33 ist eingerichtet gemäß einem der Beispiele 1 bis 32, wobei dem Hohlraum im Betrieb ein Arbeitsgas und/oder Reaktivgas zugeführt wird.

### Es zeigen

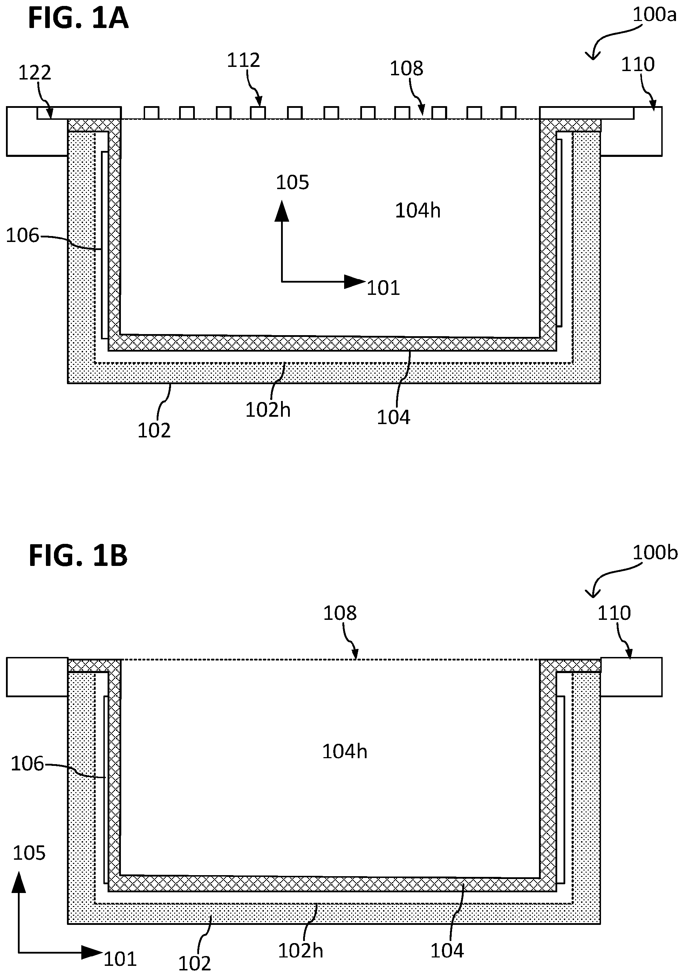

Figur 1A bis 5B die Vakuumanordnung in verschiedenen schematischen Ansichten.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung (z.B. ohmsch und/oder elektrisch leitfähig, z.B. einer elektrisch leitfähigen Verbindung), eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

Gemäß verschiedenen Ausführungsformen kann der Begriff "gekoppelt" oder "Kopplung" im Sinne einer (z.B. mechanischen, hydrostatischen, thermischen und/oder elektrischen), z.B. direkten oder indirekten, Verbindung und/oder Wechselwirkung verstanden werden. Mehrere Elemente können beispielsweise entlang einer Wechselwirkungskette miteinander gekoppelt sein, entlang welcher die Wechselwirkung ausgetauscht werden kann, z.B. ein Fluid (dann auch als fluidleitend gekoppelt bezeichnet). Beispielsweise können zwei miteinander gekoppelte Elemente eine Wechselwirkung miteinander austauschen, z.B. eine mechanische, hydrostatische, thermische und/oder elektrische Wechselwirkung. Eine Kopplung mehrerer Vakuumkomponenten (z.B. Ventilen, Pumpen, Kammern, usw.) miteinander kann aufweisen, dass diese fluidleitend miteinander gekoppelt sind. Gemäß verschiedenen Ausführungsformen kann "gekuppelt" im Sinne einer mechanischen (z.B. körperlichen bzw. physikalischen) Kopplung verstanden werden, z.B. mittels eines direkten körperlichen Kontakts. Eine Kupplung kann eingerichtet sein, eine mechanische Wechselwirkung (z.B. Kraft, Drehmoment, etc.) zu übertragen.

Der Begriff Hochfrequenz (HF) bezeichnet hierin eine Frequenz von mehr als 1 kHz (Kilohertz) verstanden, z.B. von mehr als ungefähr 1 MHz (Megahertz), z.B. von mehr als ungefähr 1 GHz (Gigahertz). Generell wird der Wert der Hochfrequenz nach oben hin nur technisch beschränkt, kann aber weniger sein als ungefähr 1000 Terahertz. Diesbezüglich wird hierin exemplarische auf eine Frequenz zum Betrieb der Plasmaquelle (auch als Betriebsfrequenz bezeichnet) von 13,56 MHz Bezug genommen. Es kann verstanden, dass das hierfür Beschriebene für jede andere Betriebsfrequenz gelten kann, z.B. von 40 KHz, von 27,12 MHz, oder von 2,45 GHz. Alternativ oder zusätzlich kann die Betriebsfrequenz in einem Bereich sein von ungefähr 1 Mhz bis ungefähr 100 MHz.

Gemäß verschiedenen Ausführungsformen kann mittels einer Plasmaquelle ein plasmabildendes Gas ionisiert werden, wobei mittels des dabei gebildeten Plasmas ein Substrat prozessiert werden kann. Zum Erzeugen eines Plasmas kann an eine Elektrode (kurz auch als Hauptelektrode bezeichnet) der Plasmaquelle eine Spannung (z.B. eine Hochfrequenz aufweisend) angelegt werden, beispielsweise indem die Hauptelektrode als Kathode betrieben wird. Auch wenn die Spannung eine Wechselspannung aufweist, wird die Begrifflichkeit der Kathode beibehalten.

Beispiele für Prozesse, welche mittels des Plasmas erfolgen können, weisen auf: Ionenstrahl-unterstütztes Abscheiden (IBAD), Plasma-Ätzen (IBE, RIBE), Plasma-Reinigen, Plasma-Konditionieren, Bereitstellen von atomaren Spezies (z.B. Sauerstoff, Stickstoff).

Das plasmabildende Gas kann beispielsweise ein oder mehr als ein Reaktivgas und/oder ein oder mehr als ein (z.B. inertes) Arbeitsgas aufweisen. Das Reaktivgas kann ein gasförmiges Material aufweisen, welches mit dem Substrat reagiert und/oder mittels einer chemischen Reaktion in das Substrat eingebaut werden kann, z.B. Sauerstoff, Stickstoff, Stickoxide, Kohlenstoffoxide und/oder Ozon). Wird beispielsweise ein Substrat verwendet, welches ein Nitrid (z.B. AlNy) bilden kann, kann das Reaktivgas Stickstoff aufweisen oder daraus gebildet sein. Wird beispielsweise ein Substrat verwendet, welches ein Oxid (z.B. AlOx) bilden kann, kann das Reaktivgas Sauerstoff aufweisen oder daraus gebildet sein. Das Reaktivgas kann beispielsweise ein Gasgemisch (Reaktivgasgemisch) aus mehreren Gasen aufweisen oder daraus gebildet sein, welche mit dem Substrat und/oder einer darauf abgeschiedenen Schicht reagieren, z.B. Sauerstoff und Stickstoff. Gemäß verschiedenen Ausführungsformen kann das Reaktivgas mindestens eines von Folgendem aufweisen: Sauerstoff, Stickstoff, Schwefelwasserstoff, Methan, gasförmige Kohlenwasserstoffe, Fluor, Chlor, oder ein anderes gasförmiges Material.

Gemäß verschiedenen Ausführungsformen kann das Arbeitsgas ein gasförmiges Material aufweisen, welches reaktionsträge ist, mit anderen Worten welches sich nur an wenigen chemischen Reaktionen beteiligt. Ein Arbeitsgas kann beispielsweise von dem verwendeten Substrat definiert sein oder werden und an dieses angepasst sein oder werden. Beispielsweise kann ein Arbeitsgas ein Gas oder ein Gasgemisch aufweisen, welches mit dem Substrat nicht (z.B. zu einem Feststoff) reagiert. Das Arbeitsgas kann beispielsweise ein Edelgas (z.B. Helium, Neon, Argon, Krypton, Xenon, Radon) oder mehrere Edelgase aufweisen. Aus dem Arbeitsgas kann das Plasma gebildet werden. Das Reaktivgas kann eine höhere chemische Reaktivität als das Arbeitsgas aufweisen, z.B. bezüglich des Substrats.

Als Montagevorrichtung wird hierin eine Vorrichtung verstanden, welche zum Montieren eingerichtet ist, beispielsweise zum Montieren an einer dazu komplementären Montagevorrichtung (auch als Gegen-Montagevorrichtung bezeichnet). Beim Montierens erfolgt ein (z.B. starres) Verbinden mehrerer Komponenten miteinander mittels ihrer Montagevorrichtungen. Das Montieren kann (beispielsweise ausschließlich) formschlüssig und/oder lösbar erfolgen. Die Montagevorrichtung kann vorzugsweise eine (z.B. planare) Montagefläche aufweisen, welche beim Montieren an einer dazu komplementären Montagefläche der Gegen-Montagevorrichtung anliegt. Die Montagevorrichtung kann beispielsweise ein oder mehr als ein (z.B. integrales) Montageprofil (z.B. Formschlussprofil) aufweisen, welches beispielsweise mittels einer Unebenheit (z.B. Vorsprung oder Vertiefung) der Montagevorrichtung bereitgestellt ist. Beispiele für das Montageprofil weisen auf: ein Gewinde, eine Nut (z.B. zur Passfederaufnahme und/oder Schwalbenschwanznut), eine Rastnase, ein Bajonettverschluss, ein Zapfen, usw. Beispiele für die Unebenheit weisen auf: eine Öffnung (z.B. Durchgangsöffnung und/oder Gewindebohrung), ein Bolzen (z.B. ein Gewindebolzen).

Eine exemplarische Implementierung der Montagevorrichtung ist als Flansch eingerichtet, z.B. als Vakuumflansch. Der Flansch kann zum starren und/oder lösbaren Verbinden mit einem anderen Flansch eingerichtet sein. Zwei miteinander verbundene Flansche bilden eine sogenannte Flanschverbindung. Der Flansch kann eine (z.B. planare) Montagefläche aufweisen. Optional kann der Flansch von einer Öffnung (auch als Flanschöffnung bezeichnet) durchdrungen sein, welche von der Montagefläche umgeben wird, z.B. entlang eines in sich geschlossenen Pfades. Die Flanschverbindung kann aufweisen, dass zwei Flansche mit ihren Montageflächen einander zugewandt angeordnet sind, z.B. einander berührend. Die Flanschöffnung eines Vakuumkammergehäuses kann in dem Kammerinnenraum des Vakuumkammergehäuses münden, z.B. an diesen angrenzend. Optional kann der Flansch eine Nut aufweisen, welche die Flanschöffnung umgibt, z.B. entlang des in sich geschlossenen Pfades die Flanschöffnung umlaufend, und/oder an die Montagefläche, angrenzt. In der Nut kann optional eine Dichtung aufgenommen sein oder werden, z.B. eine Metalldichtung oder eine Kunststoffdichtung. Optional kann der Flansch einen Vorsprung aufweisen, der die Montagefläche aufweist. Beispielsweise kann die Montagefläche hervorstehen.

Komplexe Prozesse können eine wirkungsvolle Gasseparation (Gastrennung) erfordern als mittels einer Kammerwand mit einer Substrat-Transfer-Öffnung erreicht werden kann. Beispielsweise kann eine Beschichtung von Substraten mit Lagen unterschiedlicher Zusammensetzung (z.B. unterschiedlicher Materialien) verschiedene Prozessbedingungen (z.B. metallisch gegenüber reaktiv/oxydisch oder unterschiedliche Reaktivgaszusammensetzungen wie Ar/N₂ gegenüber Ar/O₂) und damit verbunden eine wirkungsvolle gastechnische Trennung der Prozessbedingungen voneinander erfordern, welche ein Vermischen der sich voneinander unterscheidenden Prozessbedingungen verringert (Gasseparation).

Die Gasseparation beschreibt anschaulich einen Unterschied (z.B. Gradienten) im Gasdruck oder in der Gaszusammensetzung zwischen vakuumtechnisch miteinander verbundenen Bereichen (z.B. gasseparierten Bereichen). Die Bauelemente (z.B. die Teile einer Gasseparationsvorrichtung), welche zur Gasseparation beitragen, können derart eingerichtet sein, dass der Unterschied im Gasdruck oder in der Gaszusammensetzung zwischen vakuumtechnisch miteinander verbundenen Bereichen (z.B. gasseparierten Bereichen) aufrecht erhalten werden kann (z.B. stabil). Mit anderen Worten kann ein Gasaustausch zwischen vakuumtechnisch miteinander verbundenen und voneinander gasseparierten Bereichen gehemmt werden, z.B. je größer die Gasseparation zwischen den Bereichen ist.

Die Gasseparationsvorrichtung (z.B. ein Gasseparationskanal) kann im Allgemeinen ein Minimum des Leitwerts (z.B. entlang des Transportpfads) implementieren, d.h. dass der Leitwerts entlang des Transportpfads in die Gasseparationsvorrichtung hinein abnimmt und entlang des Transportpfads aus der Gasseparationsvorrichtung heraus wieder zunimmt. Der Begriff "Leitwert" (beispielsweise Gasleitwert oder allgemeiner Fluidleitwert) eines Körpers kann als Maß für dessen Durchlässigkeit für einen Materialstrom verstanden werden. Der Leitwert gibt an, welches Volumen des Materialstroms durch den Körper hindurchtritt, wenn dieser einem Druckunterschied (auch als Druckgefälle bezeichnet) des Materialstroms ausgesetzt ist. Der Gasleitwert kann indirekt proportional sein zu dem Strömungswiderstand, den der Materialstrom beim Durchtritt durch den Körper erfährt. Der Gasleitwert einer Düse ist eine Funktion der Strecke, die der Materialstrom durch die Düse hindurch zurücklegt (auch als Länge der Düsenöffnung oder Düsenlänge bezeichnet), der Querschnittsfläche der Düsenöffnung und/oder der Form der Düsenöffnung.

Gemäß verschiedenen Ausführungsformen kann die Vakuumkammer mittels eines Kammergehäuses bereitgestellt sein oder werden, in dem eine Kammer oder mehrere Kammern bereitgestellt sein oder werden können. Das Kammergehäuse kann beispielsweise zum Bereitstellen eines Unterdrucks oder eines Vakuums (Vakuumkammergehäuse) mit einer Pumpenanordnung, z.B. einer Vakuumpumpenanordnung, (z.B. gasleitend) gekoppelt sein und derart stabil eingerichtet sein, dass diese dem Einwirken des Luftdrucks im abgepumpten Zustand standhält. Die Pumpenanordnung (aufweisend zumindest eine Vakuumpumpe, z.B. eine Hochvakuumpumpe, z.B. eine Turbomolekularpumpe) kann es ermöglichen, einen Teil des Gases aus dem Inneren der Prozessierkammer, z.B. aus dem Prozessierraum, abzupumpen. Dementsprechend kann eine Vakuumkammer oder können mehrere Vakuumkammern in einem Kammergehäuse bereitgestellt sein. Mit anderen Worten kann das Kammergehäuse als Vakuumkammergehäuse eingerichtet sein bzw. kann eine Beschichtungskammer als eine Vakuumkammer eingerichtet sein.

Der Begriff "Vakuumdruck" bezeichnet hierin einen Unterdruck im Bereich des Vakuums (d.h. ein Druck von weniger als 0,3 bar), z.B. ein Druck in einem Bereich von ungefähr 10 mbar bis ungefähr 1 mbar (mit anderen Worten Grobvakuum) bereitgestellt werden kann oder weniger, z.B. ein Druck in einem Bereich von ungefähr 1 mbar bis ungefähr 10⁻³ mbar (mit anderen Worten Feinvakuum) oder weniger, z.B. ein Druck in einem Bereich von ungefähr 10⁻³ mbar bis ungefähr 10⁻⁷ mbar (mit anderen Worten Hochvakuum) oder weniger, z.B. ein Druck von kleiner als Hochvakuum, z.B. kleiner als ungefähr 10⁻⁷ mbar.

Eine Elektrode kann gemäß verschiedenen Ausführungsformen elektrisch leitfähig (z.B. eine elektrische Leitfähigkeit von mehr als 10⁴ Siemens pro Meter aufweisend) und/oder metallisch sein. Die Elektrode kann beispielsweise ein Metall aufweisen oder daraus bestehen und/oder plattenförmig sein.

**Fig.1A** veranschaulicht eine Plasmaquelle gemäß verschiedenen Ausführungsformen 100a in einer schematischen Seitenansicht oder Querschnittsansicht, vorzugsweise eingerichtet gemäß Beispiel von Beispiel 21 bis Beispiel 24.

Eine exemplarische Implementierung zum Betrieb der Plasmaquelle weist auf, in dem Hohlraum 102h (auch als Quelleninnenraum 102h bezeichnet) der Plasmaquelle, z.B. der darin angeordneten Vertiefung 104h (auch als Plasmabildungsraum 104h bezeichnet) der Schutzstruktur 104, eine Plasmabildung anzuregen, um darin ein Plasma zu bilden. Die Plasmabildung kann mittels einer Hochfrequenz als Betriebsfrequenz und/oder mittels Ionisierens des plasmabildenden Gases erfolgen.

Eine exemplarische Implementierung der Schutzstruktur 104 weist einen Glastopf auf, welcher den Plasmabildungsraum 104h aufweist. Alternativ oder zusätzlich weist die Plasmaquelle Austrittsöffnung 108 auf, welche aus einer Emissionsrichtung 105 an den Plasmabildungsraum 104h angrenzt und/oder in dem Quelleninnenraum 102h mündet.

Eine exemplarische Implementierung der Plasmabildung erfolgt mittels einer Hauptelektrode 106, an welche im Betrieb die Betriebsfrequenz angelegt ist. Die Hauptelektrode 106 kann beispielsweise in dem Quelleninnenraum 102h angeordnet sein und/oder zwischen dem Plasmaquellengehäuse 102 und der Schutzstruktur 104 angeordnet sein. Die Betriebsfrequenz kann mittels eines Generators (auch als Hochfrequenz-Generator bezeichnet) bereitgestellt sein oder werden.

Eine exemplarische Implementierung des Plasmaquellengehäuses 102 ist an einem Vakuumflansch 110 befestigt, welcher die Austrittsöffnung 108 entlang eines in sich geschlossenen Pfades umläuft. Alternativ oder zusätzlich weisen das Plasmaquellengehäuse 102 und/oder der Vakuumflansch 110 eine vertiefte Montagefläche auf, an welcher die Gitterelektrode 112 anliegt oder zumindest montiert werden kann. Die Gitterelektrode 112 kann entlang der Emissionsrichtung 105 von einer Vielzahl von Durchgangsöffnung durchdrungen sein und/oder eine Vielzahl von metallischen Filamenten aufweisen, welche den Quelleninnenraum 102h begrenzen. Alternativ oder zusätzlich kann die Gitterelektrode 112 an der Schutzstruktur 104 anliegen.

Eine exemplarische Implementierung der Hauptelektrode 106 ist galvanisch von dem Plasmaquellengehäuse 102 separiert und/oder mit dem Generator gekoppelt. Alternativ oder zusätzlich ist das Plasmaquellengehäuse 102 im Betrieb geerdet.

Die Plasmaquelle kann als hochfrequenzangeregte Plasmastrahlquelle, z.B. magnetfeldunterstützte und/oder filamentlose Plasmastrahlquelle, eingerichtet sein. Die Gitterelektrode 112 kann eingerichtet sein, im Betrieb das die Gitterelektrode 112 passierende Material (z.B. Teile des Plasmas aufweisend) zu neutralisieren. Ist die Gitterelektrode montiert, kann die Plasmaquelle beispielsweise einen quasineutralen Plasmastrahl in die Emissionsrichtung 105 zu emittieren. Quasineutral kann verstanden werden, als im Mittel gleich viele Ionen als auch Elektronen aufweisend.

Das Einkoppeln von elektrischer Leistung in das Plasma, die mittels eines Hochfrequenz-Generators (nicht dargestellt) bereitgestellt wird, kann mittels der Hauptelektrode 106 erfolgen. Dazu kann optional ein Hochfrequenz-Anpassnetzwerk (z.B. eine oder mehr als eine Luftspule und/oder einen oder mehr als einen Kondensator aufweisend) vorhanden sein, um die Impedanz der Plasmaquelle an die Impedanz des Hochfrequenz-Generators anzugleichen.

Eine exemplarische Implementierung (vorzugsweise gemäß Beispiel 21) der ersten Montagevorrichtung 122 (auch als Gittermontagevorrichtung bezeichnet) ist als Flansch eingerichtet zum Montieren einer Gitterelektrode 112. Es kann verstanden werden, dass die Gittermontagevorrichtung nicht vorhanden ist, wenn die Plasmaquelle eine gitterlose Plasmaquelle ist. Es kann verstanden werden, dass die Gittermontagevorrichtung demontiert sein kann, wenn die Plasmaquelle eine gitteraufweisende Plasmaquelle ist.

Die Gittermontagevorrichtung 122 weist beispielsweise eine rahmenförmige Vertiefung auf, welche von einer Montagefläche begrenzt wird, die in die Emissionsrichtung 105 gerichtet ist. Die Montagefläche umläuft die Austrittsöffnung 108 entlang eines in sich geschlossenen Pfades.

Eine exemplarische Implementierung der zweiten Montagevorrichtung (auch als Gehäusemontagevorrichtung bezeichnet) ist als nach außen auskragender Vakuumflansch 110 bereitgestellt, welcher die Austrittsöffnung 108 und/oder die Gittermontagevorrichtung (insofern vorhanden) entlang eines in sich geschlossenen Pfades umläuft. Der Vakuumflansch 110 kann mehrere Durchgangsöffnung aufweisen, welche entlang der Emissionsrichtung 105 erstreckt sind, zum Montieren der Gehäusemontagevorrichtung an dem Vakuumkammergehäuse. Ferner weist der Vakuumflansch 110 eine Dichtnut auf zum Aufnehmen eines Dichtrings.

**Fig.1B** veranschaulicht eine Plasmaquelle gemäß verschiedenen Ausführungsformen 100b in einer schematischen Seitenansicht oder Querschnittsansicht, vorzugsweise eingerichtet gemäß einer der Ausführungsformen 100a, z.B. gemäß Beispiel 21 oder Beispiel 22, wobei die Gitterelektrode 112 weggelassen oder demontiert ist (dann auch als gitterlose Plasmaquelle bezeichnet).

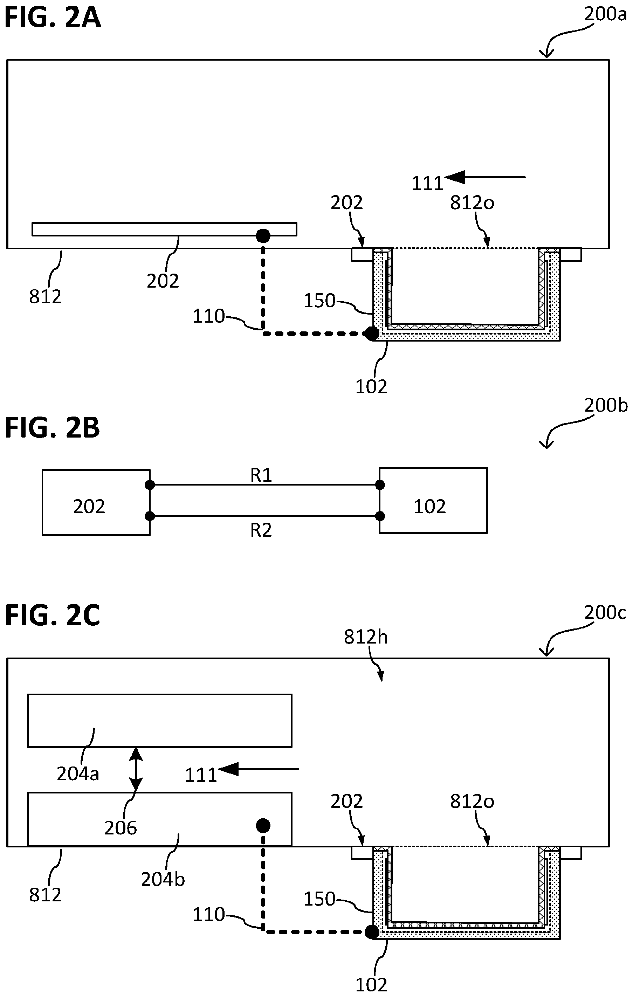

Eine exemplarische Implementierung der gitterlosen Plasmaquelle gemäß Ausführungsformen 100b wird bereitgestellt, indem die Gitterelektrode 112 (auch als gitterförmige Elektrode 112bezeichnet), welche den Hohlraum 104h begrenzt, entfernt wird, und ohne die Gitterelektrode 112 an dem Vakuumkammergehäuse montiert und/oder betrieben wird. Mittels der so bereitgestellten gitterlosen Plasmaquelle gemäß Ausführungsformen 100b erfolgt das Bilden eines Plasmas in dem Plasmabildungsraum 104h, dem der Transportpfad 111 ausgesetzt ist, beispielsweise wenn ein Substrat mittels der Transportvorrichtung (nicht dargestellt) entlang des Transportpfads 111 transportiert wird. Ferner erfolgt das Verwenden einer Wand, vorzugsweise einer Gasseparationswand (siehe auch Fig.2C), welche in dem Vakuumkammergehäuse 812 angeordnet ist, als Kammerelektrode für die gitterlose Plasmaquelle, insbesondere wenn im Betrieb in dem Plasmabildungsraum 104h das Plasmas gebildet wird. Die Kammerelektrode hemmt die räumliche Ausbreitung des Plasmas, was die Lebensdauer der Vakuumanordnung vergrößert, selbst wenn die Gitterelektrode montiert ist.

**Fig.2A** veranschaulicht eine Vakuumkammeranordnung 200a gemäß verschiedenen Ausführungsformen in einer schematischen Seitenansicht oder Querschnittsansicht, vorzugsweise eingerichtet gemäß einer der Ausführungsformen 100a bis 100b und/oder gemäß Beispiel 2.

Eine exemplarische Implementierung des Vakuumkammergehäuses 812 weist einen Vakuumflansch 202 auf, an welchen die Plasmaquelle 150, z.B. deren Vakuumflansch, montiert ist. Ferner weist das Vakuumkammergehäuse 812 eine Kammeröffnung 812o auf, an welche die Plasmaquelle, z.B. deren Austrittsöffnung 108, angrenzt. Die Kammeröffnung mündet in dem Innenraum des Vakuumkammergehäuses 812 (auch als Gehäuseinnenraum bezeichnet). Der Transportpfad 111 kann in dem Innenraum des Vakuumkammergehäuses 812 angeordnet sein.

Eine exemplarische Implementierung der Kammerelektrode 202 ist neben der Kammeröffnung 812o angeordnet und/oder plattenförmig. Die Kammerelektrode 202 berührt ferner eine Wand des Vakuumkammergehäuses 812 (auch als Gehäusewand bezeichnet) berührend.

Eine exemplarische Implementierung der Hochfrequenz-Übertragungsvorrichtung 110 (auch als HF-Übertragungsvorrichtung 110 bezeichnet) koppelt die Kammerelektrode 202 mit dem Plasmaquellengehäuse 102, z.B. parallel geschaltet zu dem Vakuumkammergehäuse 812. Alternativ oder zusätzlich ist die HF-Übertragungsvorrichtung 110 durch eine Durchgangsöffnung in dem Vakuumkammergehäuse 812 hindurch erstreckt.

Anschaulich reduziert die HF-Übertragungsvorrichtung 110 die Impedanz zwischen der Kammerelektrode 202 und dem Plasmaquellengehäuse 102. Daher müssen die HF-Übertragungsvorrichtung 110 und/oder die Kammerelektrode 202 nicht notwendigerweise galvanisch separiert sein von dem Plasmaquellengehäuse 102, sondern können wahlweise auch ohmsch mit diesen gekoppelt sein.

**Fig.2B** veranschaulicht eine Vakuumanordnung gemäß verschiedenen Ausführungsformen 200b in einem schematischen Diagramm als Ersatzschaltbild, vorzugsweise eingerichtet gemäß einer der Ausführungsformen 100a bis 200a und/oder Beispiel 10.

Die Vakuumanordnung kann mehrere Strompfade implementieren, welche parallel zueinander die Kammerelektrode 202 mit Plasmaquellengehäuse koppeln, wovon ein erster Strompfad mittels des Plasmaquellengehäuses 102 implementiert wird und eine erste Impedanz R1 aufweist, und wovon ein zweiter Strompfad mittels der Übertragungsvorrichtung 110 implementiert wird und eine zweite Impedanz R2 aufweist. Die erste und die zweite Impedanz können die folgende Relation erfüllen, z.B. für eine Hochfrequenz (z.B. die Betriebsfrequenz): R2<R1, z.B. R1 = 10^{k}·R2, wobei k≥0 (z.B. k≥1, k≥2, k≥3 oder k≥4) und/oder k≤10 sein kann.

**Fig.2C** veranschaulicht eine Vakuumanordnung gemäß verschiedenen Ausführungsformen 200c in einem schematischen Ersatzschaltbild, vorzugsweise eingerichtet gemäß einer der Ausführungsformen 100a bis 200b und/oder Beispiel 13.

Eine exemplarische Implementierung des Gasseparationskanals (auch als kanalförmige Gasseparationsvorrichtung bezeichnet) weist zwei plattenförmige Gasseparationswände 204a, 204b auf, zwischen denen ein Gasseparationsspalt 206 (anschaulich eine Verengung) gebildet ist, durch welchen hindurch der Transportpfad 111 verläuft. Der Gasseparationsspalt 206 kann zwei Bereiche des Kammerinnenraums 812h des Vakuumkammergehäuse 812 voneinander gasseparieren. Eine oder mehr als eine der zwei Gasseparationswände 204a, 204b kann als Kammerelektrode 202 mittels einer Übertragungsvorrichtung 110 mit dem Plasmaquellengehäuses 102 gekoppelt sein und somit als Kammerelektrode betrieben werden.

Eine exemplarische Implementierung der Vakuumanordnung weist zwei Gasseparationskanäle auf, zwischen denen ein Vakuumbereich angeordnet ist, an welchen eine Prozessiervorrichtung (z.B. die Plasmaquelle und optional eine Beschichtungsvorrichtung aufweisend) angrenzt (auch als Prozessierbereich bezeichnet). Beispielsweise kann Vakuumanordnung zwei Prozessierbereiche aufweisen, zwischen denen der Gasseparationskanal angeordnet ist und in welche der Gasseparationsspalt 206 mündet.

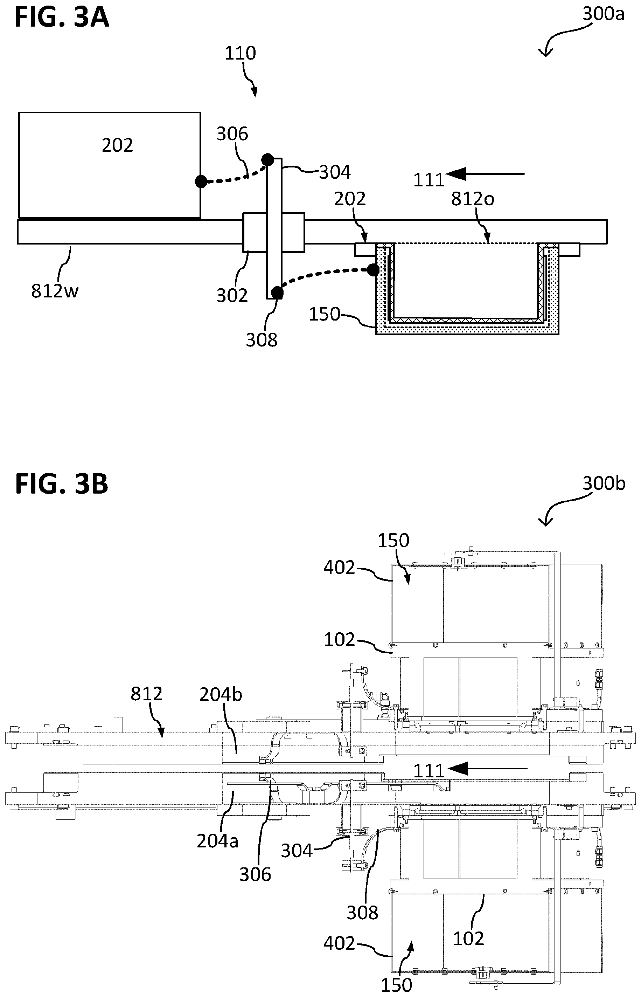

**Fig.3A** veranschaulicht eine Vakuumkammeranordnung 300a gemäß verschiedenen Ausführungsformen in einer schematischen Seitenansicht oder Querschnittsansicht, vorzugsweise eingerichtet gemäß einer der Ausführungsformen 100a bis 200b und/oder gemäß Beispiel 6 oder Beispiel 7.

Eine exemplarische Implementierung der Übertragungsvorrichtung 110 (vorzugsweise gemäß Beispiel 7 und/oder Beispiel 9) weist einen Kupferstab 304 auf, welcher mittels einer Vakuumdurchführung 302 gehalten ist, die in einer Durchgangsöffnung (auch als Wandöffnung bezeichnet) des Vakuumkammergehäuses 812 (z.B. einer Kammerwand 812w dessen) angeordnet ist. Der Kupferstab 304 kann durch die Vakuumdurchführung 302 und/oder die Kammerwand 812w hindurch erstreckt sein. Ferner weist die Übertragungsvorrichtung 110 zwei (z.B. in Reihe verschaltete) Hochfrequenzlitzen (HF-Litzen) auf, welche mittels des Kupferstabs 304 miteinander gekoppelt sind und wovon eine erste HF-Litze 306 zwischen die Kammerelektrode 202 und den Kupferstab 304 geschaltet ist, und wovon eine zweite HF-Litze 308 zwischen das Plasmaquellengehäuse 102 und den Kupferstab 304 geschaltet ist.

Eine exemplarische Implementierung der HF-Litze weist eine Vielzahl metallischer Filamenten (z.B. aus Kupfer) auf, wovon optional jedes Filament beschichtet ist, z.B. mit einem Dielektrikum (z.B. einem dielektrischen Polymer) und/oder mit Silber. Jedes Filament kann beispielsweise aus einem Kupferdraht bestehen. Die Anzahl N der Filamente pro HF-Litze kann beispielsweise N≥10^{k} sein, wobei k≥0 sein kann (z.B. k≥1, k≥2, k≥3 oder k≥4) und/oder k≤10 sein kann. Je größer N, desto geringer ist die Impedanz des der HF-Litze. Die Vielzahl Filamente ist ferner miteinander verflochten oder verdrillt, was die Impedanz der HF-Litze mindert.

Ein elektrischer Stromfluss bei Hochfrequenz fließt anschaulich im Wesentlichen nur an der Oberfläche der Filamente. Beispielsweise beträgt bei einer Frequenz von 10 MHz die Stromdichte 20 µm unter der Oberfläche weniger als 37 % der Stromdichte auf der äußersten Oberfläche.

**Fig.3B** veranschaulicht eine Vakuumanordnung gemäß verschiedenen Ausführungsformen 300b in einem schematischen Ersatzschaltbild, vorzugsweise eingerichtet gemäß einer der Ausführungsformen 100a bis 300a und/oder gemäß Beispiel 6 oder Beispiel 7.

Eine exemplarische Implementierung der Vakuumanordnung weist mehrere Baugruppen auf, z.B. zwei Baugruppen, zwischen denen der Transportpfad 111 angeordnet ist, wovon jede Baugruppe aufweist:
- eine Plasmaquelle 150;
- eine Gastrennwand 204a, 204b, welche als Kammerelektrode 202 eingerichtet ist;
- eine HF-Übertragungsvorrichtung 110, welches zwischen das Plasmaquellengehäuse 102 der Plasmaquelle 150 und die Gastrennwand 204a geschaltet ist, z.B. parallel zu dem Vakuumkammergehäuse 812.

Eine exemplarische Implementierung der Plasmaquelle 150 weist einen elektrischen Generator 402 auf, welcher eingerichtet ist, die Betriebsfrequenz zu erzeugen und der Hauptelektrode 106 zuzuführen. Der Generator 402 ist mit dem Plasmaquellengehäuse 102 gekuppelt, z.B. daran befestigt, was eine kompakte Bauform ermöglicht.

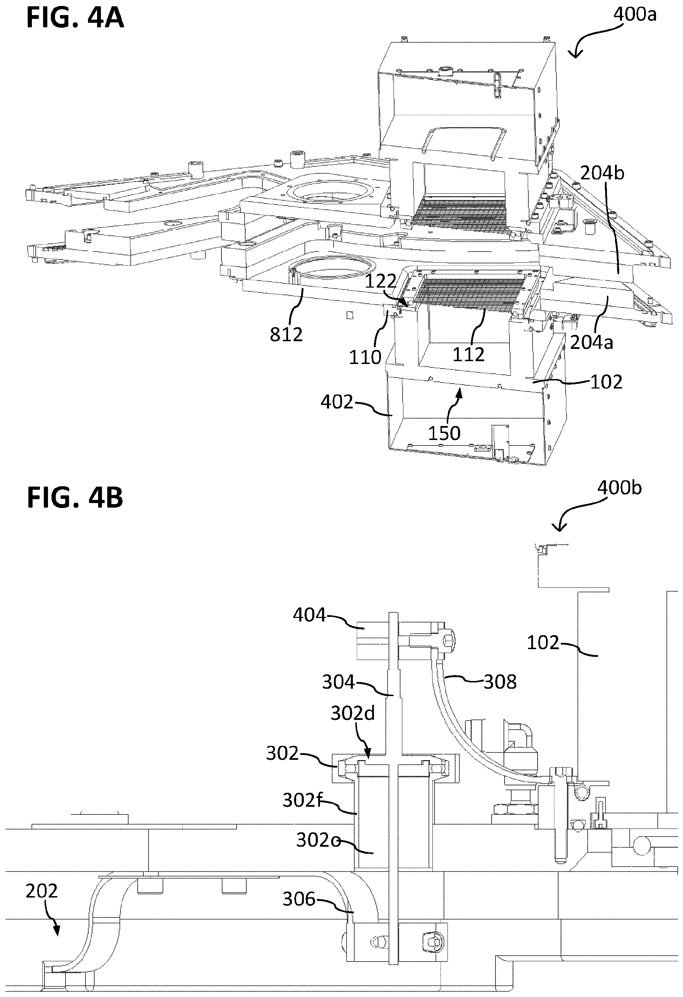

**Fig.4A** veranschaulicht eine Vakuumkammeranordnung 400a gemäß verschiedenen Ausführungsformen in einer schematischen geschnittenen Perspektivansicht, vorzugsweise eingerichtet gemäß einer der Ausführungsformen 100a bis 300b und/oder gemäß Beispiel 6 oder Beispiel 7. Wie hierin erläutert, kann die Gitterelektrode 112 demontiert sein oder werden, so dass eine gitterlose Plasmaquelle bereitgestellt wird.

**Fig.4B** veranschaulicht eine Vakuumanordnung gemäß verschiedenen Ausführungsformen 400b in einer schematischen Detailansicht auf die Kupplungsvorrichtung 110, vorzugsweise eingerichtet gemäß einer der Ausführungsformen 100a bis 400a und/oder gemäß Beispiel 6 oder Beispiel 7.

Eine exemplarische Implementierung der Vakuumdurchführung 302 weist einen Flansch 302f auf, welcher von der Wandöffnung 302o durchdrungen ist und/oder welcher mit einem Deckel 302d abgedichtet ist. Der Deckel 302d ist monolithisch mit dem Kupferstab 304 verbunden.

Eine exemplarische Implementierung der Übertragungsvorrichtung 110 weist, pro HF-Litze 306, eine Schraubkupplung 404 auf, mittels welcher die HF-Litze 306 mit dem Kupferstab 304 gekuppelt ist.

Eine exemplarische Implementierung der HF-Litze 306 ist als Flachlitze eingerichtet.

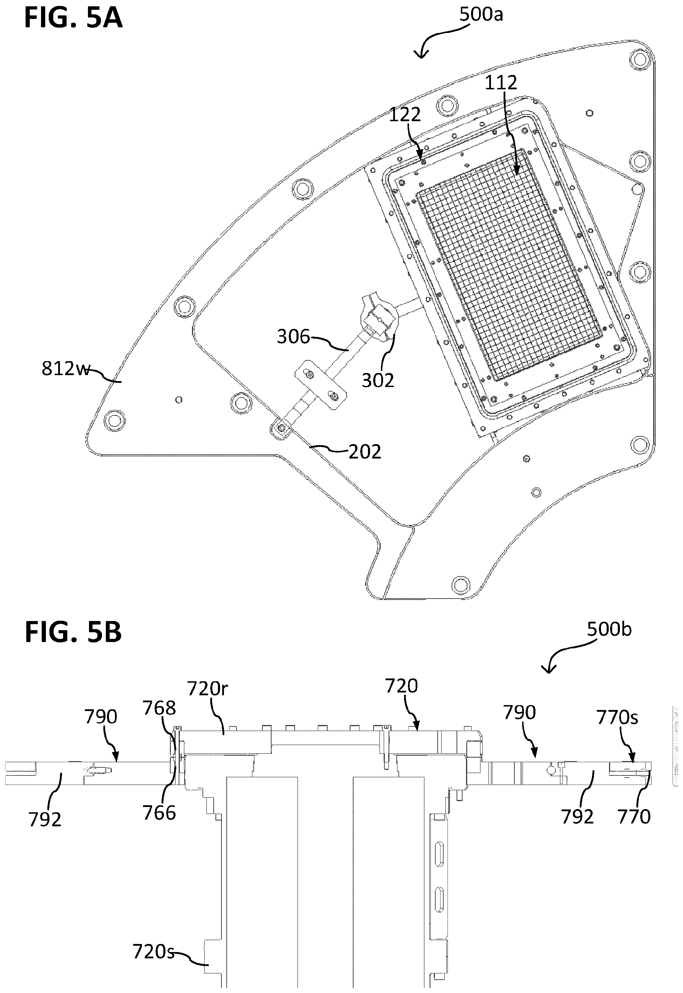

**Fig.5A** veranschaulicht eine Vakuumkammeranordnung 500a gemäß verschiedenen Ausführungsformen in einer schematischen geschnittenen Draufsicht vom Transportpfad aus, vorzugsweise eingerichtet gemäß einer der Ausführungsformen 100a bis 400b und/oder gemäß Beispiel 21 und/oder Beispiel 22. Es kann verstanden werden, dass die Gitterelektrode 112 demontiert und/oder im Betrieb der Plasmaquelle weggelassen werden kann.

Eine exemplarische Implementierung der Gitterelektrode 112 weist ein rahmenförmiges Gestell auf, welches von einer Durchgangsöffnung durchdrungen ist, und eine Vielzahl von Filamenten, welche ein Gitter bilden, das in der Durchgangsöffnung angeordnet ist.

**Fig.5B** veranschaulicht eine Vakuumanordnung gemäß verschiedenen Ausführungsformen 500b in einer schematischen geschnittenen Detailansicht auf die Transportvorrichtung, vorzugsweise eingerichtet gemäß einer der Ausführungsformen 100a bis 400b und/oder gemäß Beispiel 2.

Eine exemplarische Implementierung der Transportvorrichtung ist als Drehteller-Transportvorrichtung eingerichtet, welche einen tellerförmigen Substratträger (auch als Drehteller bezeichnet) aufweist zum Transportieren eines Substrats entlang eines kreisförmigen Transportpfads. Der Drehteller weist mehrere Abschnitte auf, wovon jeder Abschnitt in einem Aufnahmespalt 770 angeordnet ist. Ferner weist die Transportvorrichtung, z.B. deren Substratträger-Haltevorrichtung 790, pro Abschnitt, einen Montagesockel 792 auf, welcher den Aufnahmespalt 770 bereitstellt. Die Transportvorrichtung weist beispielsweise mehrere Substratträger-Segmente (nicht dargestellt) auf, welche den Drehteller bereitstellen.

Eine exemplarische Implementierung des Drehtellers ist als mehrteiliger Drehteller eingerichtet, dessen Substratträger-Segmente 780 kreisringsegment-förmig sind (beispielsweise in Form von Tortenstücken). Die Transportvorrichtung weist einen Rotor 720r auf, mit welchem, pro Substratträger-Segment, einen Montagesockel 792 mit Spannbacke 770s, welche den Aufnahmespalt 770 bildet, zum Montieren und Ausrichten des Substratträger-Segments gekuppelt ist. Der Montagesockel 792 kann beispielsweise drehbar gelagert sein, beispielsweise mittels eines Drehgelenks, das eine Welle aufweist. Das Drehgelenk erleichtert es, den Substratträger zu kippen und/oder anzuheben, oder allgemeiner gesprochen, auszurichten. Ferner können zusätzliche Schrauben vorhanden sein, um resultierende Position des Drehgelenks zu arretieren.

Eine exemplarische Implementierung des Substratträgers, z.B. des Drehtellers, ist in dem Gasseparationsspalt 206 angeordnet und/oder wird durch diesen hindurch transportiert.

Eine exemplarische Implementierung der Substratträger-Haltevorrichtung 790 weist einen ersten Ring 766 auf, welcher mehrere Zähne aufweist zum Bilden einer Hirth-Verzahnung. Dazu komplementär weist der Rotor, z.B. dessen Nabe, einen zweiten Ring 768 (auch als Zahnring bezeichnet) auf, welcher mehrere Zähne aufweist zum Bilden der Hirth-Verzahnung.

Eine exemplarische Implementierung des Rotors ist mittels einer Drehdurchführung 720 bereitgestellt, deren Stator 720s an dem Vakuumkammergehäuse 712 befestigt ist (z.B. mittels Schrauben) und deren Rotor 720r an der Substratträger-Haltevorrichtung 790 befestigt ist (z.B. mittels Schrauben). Optional kann die Substratträger-Haltevorrichtung 790 mittels der Hirth-Verzahnung mit dem Rotor 720r gekuppelt sein, was die Zentrierung und die Vermittlung eines Drehmoments erleichtert.

Im Betrieb kann mittels des Substratträgers, z.B. pro Substratträger-Segment, ein Substrat transportiert werden.

Es kann verstanden werden, dass die hierin erläuterten Aspekte ebenso in einer Durchlaufanlage verwendet werden können, deren Transportvorrichtung mehrere entlang des Transportpfads hintereinander angeordnete Transportrollen aufweist.

Im Folgenden werden verschiedene Arbeitsbeispiele beschrieben, die sich auf vorangehend Beschriebene und in den Figuren Dargestellte beziehen.

In Arbeitsbeispiel 1 ist die Gitterelektrode der Plasmaquelle im Betrieb, z.B. beim Bilden des Plasmas in dem Plasmabildungsraum, weggelassen und/oder demontiert. Dann kann die Gittermontagevorrichtung beispielsweise frei gelegt sein, z.B. dem Plasma ausgesetzt sein. Dies vergrößert die Standzeit und reduziert Kosten sowie erhöht die Wartungsfreundlichkeit.

In Arbeitsbeispiel 2 wird die Gitterelektrode der Plasmaquelle funktionell ersetzt mittels eines HF-Kondensators, welcher die Kammerelektrode aufweist und eingerichtet ist, die räumliche Ausbreitung des Plasmas nahe der Plasmaquelle zu begrenzen. Dies verhindert, dass das HF-Feld den Plasmabildungsbereich verlässt und dadurch das Plasma ausbreitet, wenn die Gitterelektrode weggelassen ist und/oder demontiert ist.

In Arbeitsbeispiel 3 wird ein geerdetes Gastrennblech als Gastrennwand bereitgestellt, das ohmsch mit dem Gehäuse der Plasmaquelle gekoppelt ist über eine Litze, die viel Oberfläche bietet, um HF zu übertragen. Die Litze ist als HF-Überträger eingerichtet.

In Arbeitsbeispiel 4 wird eine elektrische Vakuumdurchführung (zumindest mittels eines Kupferstabs), bereitgestellt, um zwei Abschnitte der Litze miteinander zu verbinden.

In Arbeitsbeispiel 5 wird eine definierte Ein- und Auskopplung des HF-Feldes in der Beschichtungsanlage bereitgestellt, was auch eine parasitäre Plasmabildung hemmt.

## Patentansprüche

1. Vakuumanordnung, aufweisend:
• ein Vakuumkammergehäuse (812);
• eine Transportvorrichtung zum Transportieren eines Substrats entlang eines Transportpfads (111) innerhalb des Vakuumkammergehäuses (812);
• ein Plasmaquelle (150), welche ein Plasmaquellengehäuse (102) aufweist, in welchem ein Hohlraum (102h) bereitbestellt ist, wobei die Plasmaquelle (150) eingerichtet ist, mittels des Hohlraums (102h) ein Plasma zu bilden, dem der Transportpfad (111) ausgesetzt ist;
• eine Elektrode (202), welche in dem Vakuumkammergehäuses (812) und neben der Plasmaquelle (150) angeordnet ist;
• eine Hochfrequenz-Übertragungsvorrichtung (110), welche das Plasmaquellengehäuse (102) ohmsch mit der Elektrode (202) koppelt.

2. Vakuumanordnung gemäß Anspruch 1, wobei die HF-Übertragungsvorrichtung (110) eine oder mehr als eine elektrische Leitung aufweist, wovon:
• eine erste Leitung in dem Vakuumkammergehäuse (812) angeordnet und/oder mittels einer HF-Litze bereitgestellt ist, und/oder
• wovon eine zweite elektrische Leitung außerhalb des Vakuumkammergehäuse (812) angeordnet und/oder mittels einer HF-Litze bereitgestellt ist.

3. Vakuumanordnung gemäß einem der Ansprüche 1 bis 2, wobei das Vakuumkammergehäuses (812) eine Gehäuseöffnung aufweist, in welcher eine Vakuumdurchführung der Übertragungsvorrichtung (110) angeordnet ist.

4. Vakuumanordnung gemäß einem der Ansprüche 1 bis 3, wobei die Vakuumdurchführung einen Kupferstab aufweist, welcher durch die Gehäuseöffnung hindurch erstreckt ist und/oder welcher zwei HF-Litzen der Übertragungsvorrichtung (110) ohmsch miteinander koppelt.

5. Vakuumanordnung gemäß einem der Ansprüche 1 bis 4, wobei die Plasmaquelle (150) eine Montagevorrichtung aufweist, welche eine dem Transportpfad (111) zugewandte Montagefläche aufweist, zum Montieren einer Gitterelektrode (112) und in welcher eine Öffnung gebildet ist, die in dem Hohlraum (102h) mündet.

6. Vakuumanordnung gemäß einem der Ansprüche 1 bis 5, ferner aufweisend:
einen Gasseparationskanal, welcher zwei Gasseparationswände aufweist, zwischen denen der Transportpfad (111) angeordnet ist und wovon eine Gasseparationswand die Elektrode (202) bereitstellt.

7. Vakuumanordnung gemäß einem der Ansprüche 1 bis 6, wobei eine elektrisch Impedanz zwischen der Elektrode (202) und dem Plasmaquellengehäuse (102), welche mittels der Übertragungsvorrichtung (110) bereitgestellt ist, kleiner ist für eine Hochfrequenz als eine elektrisch Impedanz zwischen der Elektrode (202) und dem Plasmaquellengehäuse (102), welche mittels des Vakuumkammergehäuses (812) bereitgestellt ist.

8. Vakuumanordnung gemäß einem der Ansprüche 1 bis 7, wobei die Übertragungsvorrichtung (110) separat von dem Vakuumkammergehäuse (812) bereitgestellt ist.

9. Verfahren zum Betreiben der Vakuumanordnung gemäß einem der Ansprüche 1 bis 8, das Verfahren aufweisend:
• Entfernen einer Gitterelektrode (112), welche den Hohlraum (102h) begrenzt;
• Bilden eines Plasmas in dem Hohlraum (102h) mittels der Plasmaquelle (150), wenn die Gitterelektrode (112) entfernt ist.

10. Verwenden einer Wand, vorzugsweise Gasseparationswand, welche in einem Vakuumkammergehäuse (812) angeordnet ist, als Elektrode (202) für eine Plasmaquelle (150), welche ein Plasmaquellengehäuse (102) aufweist, in welchem ein Hohlraum (102h) bereitbestellt ist, wobei die Plasmaquelle eingerichtet ist, mittels des Hohlraums (102h) ein Plasma zu bilden, wobei die Elektrode (202) mittels einer HF-Übertragungsvorrichtung (110) ohmsch mit dem Plasmaquellengehäuse (102) gekoppelt ist.
